(19) **Europäisches Patentamt / European Patent Office / Office européen des brevets**

(11) **EP 2 383 756 B1**

(12) **EUROPÄISCHE PATENTSCHRIFT**

(45) Veröffentlichungstag und Bekanntmachung des Hinweises auf die Patenterteilung:
**22.10.2014 Patentblatt 2014/43**

(51) Int Cl.:
**H01F 29/14** *(2006.01)* **H02M 1/16** *(2006.01)*

(21) Anmeldenummer: **11154545.5**

(22) Anmeldetag: **15.02.2011**

(54) **Vorrichtung zur Stromverstärkung für die elektromagnetische Pulsumformung und Verwendung**

Device for current amplification for electromagnetic pulse shaping and use

Dispositif pour l'amplification de courant pour la déformation électromagnétique d'impulsions et utilisation

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**
Benannte Erstreckungsstaaten:
**BA ME**

(30) Priorität: **15.02.2010 DE 102010001934**

(43) Veröffentlichungstag der Anmeldung:
**02.11.2011 Patentblatt 2011/44**

(73) Patentinhaber: **Helmholtz-Zentrum Dresden - Rossendorf e.V.**
**01328 Dresden (DE)**

(72) Erfinder:
• **Herrmannsdörfer, Thomas, Dr.**
  **01328 Dresden (DE)**
• **Dittrich, Steffen**
  **01108 Dresden (DE)**

(74) Vertreter: **Kailuweit & Uhlemann Patentanwälte Partnerschaft mbB**
**Postfach 320 139**
**01013 Dresden (DE)**

(56) Entgegenhaltungen:
DE-A1- 19 602 951    DE-A1- 19 715 351
GB-A- 534 667    US-A- 5 011 553
US-A- 5 684 341

**Beschreibung**

Die Erfindung betrifft eine Vorrichtung zur Erzeugung und Leitung eines hohen pulsförmigen elektrischen Stromes, die z. B. zum elektromagnetischen Umformen von Werkstücken verwendet werden kann.

Die elektromagnetische Pulsumformung (EMP) ist ein seit langem bekanntes Verfahren [Dietz, H., Lippmann, H. J., Schenk, H.: "Messung der magnetischen Induktion in einer Magneform-Kompressionsspule" Elektrotechnische Zeitung - Bd. 88 Heft 19, S. 51-54]. Bei der Entwicklung von EMP-Anlagen müssen nicht nur die auftretenden Umformkräfte, sondern auch die hohen elektrischen Spannungen und Ströme beachten werden. Dadurch sind die Anlagen meist sehr komplex. Durch eine Weiterentwicklung der EMP-Technologie ergeben sich neue bzw. verbesserte Möglichkeiten bei der Bauteilfertigung, speziell für Leichtbaubauweisen, in der Automobil- oder deren Zulieferindustrie, der Luft-und Raumfahrtindustrie, bei in der Medizin oder Chemie verwendeten Anlagen und Geräten.

Beim E M P werden Werkstücke mit magnetischen Feldern umgeformt, wobei impulsförmige Ströme hoher Amplitude durch eine Spule geführt werden. Pulsgeneratoren erzeugen aus geladenen Energiespeichern (z. B. Kondensatoren) beim Anschließen von Induktivitäten (z. B. Umforminduktivität) die erforderlichen hohen impulsförmigen Ströme. Dazu werden die Kondensatoren über spezielle Ladegeräte geladen. Ein Schalter startet dann die Energieübertragung aus dem Kondensator in eine Induktivität (Umformspule) (Bild 1). Zum Erreichen sehr hoher Pulsströme sind kleine Induktivitäten erforderlich, wobei die Reduktion der Kabelinduktivität mittels einer Parallelschaltung von Kabeln erreicht werden kann.

Allerdings sind die heute zur Verfügung stehenden Pulsstromparameter noch so eingeschränkt, dass gerade eine Vielzahl höherwertiger fester Werkstoffe nicht bearbeitet werden können.

Als Schalter für diese hohen Ströme verwendet man Ignitrons, Thyratrons oder Funkenstrecken. [US 3,786,334 A]. Der Nachteil dieser Schalter ist der der hohe Verschleiß. Sie sind durch die hohen Wartungs- und Wechselintervalle nicht anwenderfreundlich. Aus sicherungstechnischen Gründen können auch bestimmte Schalter nicht verwendet werden (z. B. Quecksilber aus Arbeitsschutzgründen). Verschleißarme bzw. verschleißfreie Halbleiterschalter (z. B. Thyristoren) bieten sich als Lösung an. Diese sind sehr teuer und besitzen begrenzte maximale Stromänderungsgeschwindigkeiten, so dass deren Einsatz nur selten erfolgt.

Aufgabe der Erfindung ist es, eine kostengünstige technische Lösung anzugeben, die die Verwendung von verschleißfreien Schaltern zur elektromagnetischen Pulsumformung ermöglicht und ökonomisch vertretbar ist. Weiterhin soll eine voluminöse Parallelschaltung von vielen Kabeln vermieden werden.

Die Aufgabe wird gelöst durch die im Patentanspruch 1 beschriebenen Merkmale. Vorteilhafte Ausführungen sind in den Unteransprüchen angegeben. Die Realisierung der Aufgabe erfolgt durch die Verwendung einer sättigbaren Induktivität, die zugleich als Zuleitung zwischen Kondensator und Umformspule dient.

Die sättigbare Induktivität muss folgende Eigenschaften aufweisen:

- Im Einschaltmoment muss die Induktivität groß sein. Die Spannungshöhe muss damit einen ausreichend hohen Stromfluss ermöglichen.

- Nach der Sättigung muss die Induktivität möglichst verschwindend gering werden, um eine große Eigenfrequenz der Schaltung erreichen zu können.

Die Erfindung wird mit Abbildungen erläutert.

Abb. 1     zeigt die typische Ersatzschaltung eines Pulsgenerators zur EMP mit Thyristoren.

Abb. 2     stellt den Ausschnitt zum Aufbau der sättigbaren Induktivität aus ferromagnetischen Kernen und Sammelschienen dar.

Abb. 3     gibt eine Ersatzschaltung für den in Abb. 2 dargestellten Aufbau an.

Abb. 4     stellt den Zusammenhang der Spannungen und Ströme für den Aufbau dar.

Abb. 5     gibt eine mögliche Umsetzung der Erfindung an.

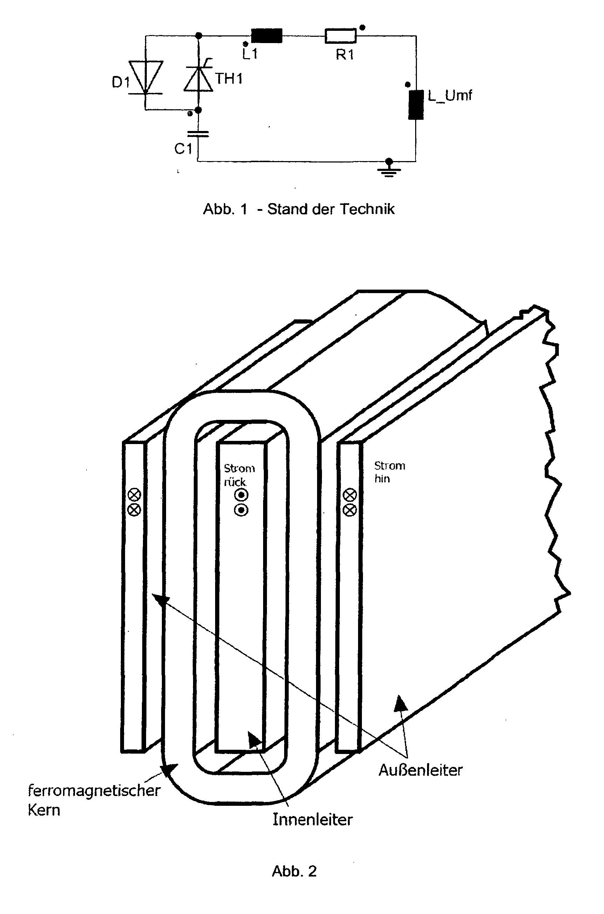

Die sättigbare Induktivität besteht, wie in Abb. 2 dargestellt, aus einer inneren Sammelschiene oder Leitung, die den Strom zur Umforminduktivität hinführt. Um diese Sammelschiene oder Leitung wird das magnetisch sättigbare Material in Form von Ringbandkernen angebracht. Diese Ringbandkerne können auch aus mehreren Teilkernen bestehen.

An einer Seite der sättigbaren Induktivität werden Sammelschienen oder Leitungen angebracht, die den Strom zurückführen. Eine weitere vorteilhafte Ausführung ist, dass die Stromzuführung an beiden Seiten oder an allen vier Seiten durch Sammelschienen oder Leitungen erfolgt.

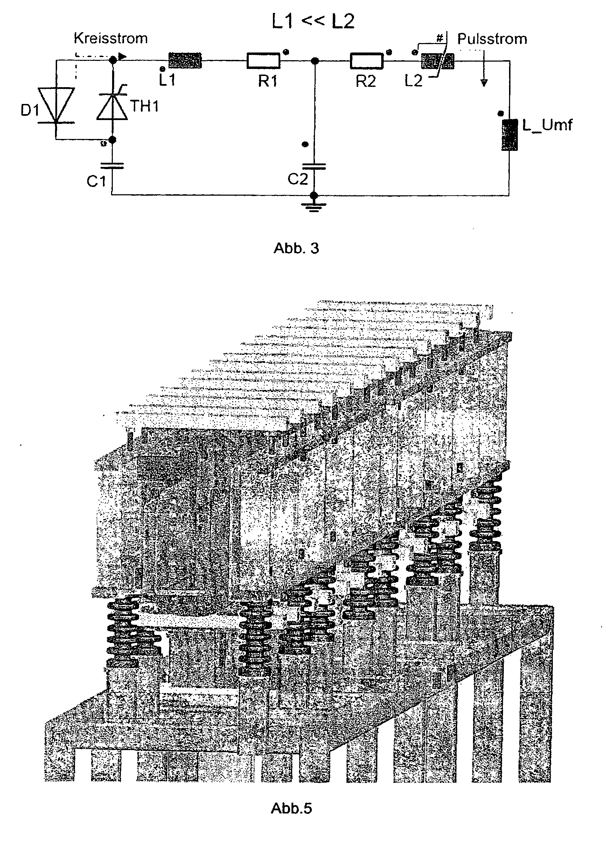

Abb. 3 stellt das Ersatzbild dar, wobei, die geladenen Kondensatoren $C_1$ mit einem Halbleiterschalter $TH_1$ über eine Drosselspule $L_1$ in ungeladene Kondensatoren $C_2$ entladen werden. Die ungesättigte Induktivität $L_2$ führt einen sehr kleinen Strom. Der durch die Drosselspule begrenzte geringere Stromanstieg ermöglicht die Verwendung verschleißfreier Halbleiterschalter. Die geladenen Kondensatoren $C_2$ entladen sich über die mittlerweile gesättigte Induktivität $L_2$ in die Umformspule $L_{Umf}$.

Optimaler Weise wird die Fläche des vom magnetischen Fluss durchsetzten Materials so bemessen, dass die Sättigung genau dann eintritt, wenn die Kondensatoren $C_2$ in dem Ersatzschaltbild auf maximale Spannung geladen sind. Die Querschnittsfläche A des ferromagnetischen Materials berechnet sich über:

$$A = \frac{U_0}{2B_S} \pi \sqrt{L_1 \frac{C_1}{2}}$$

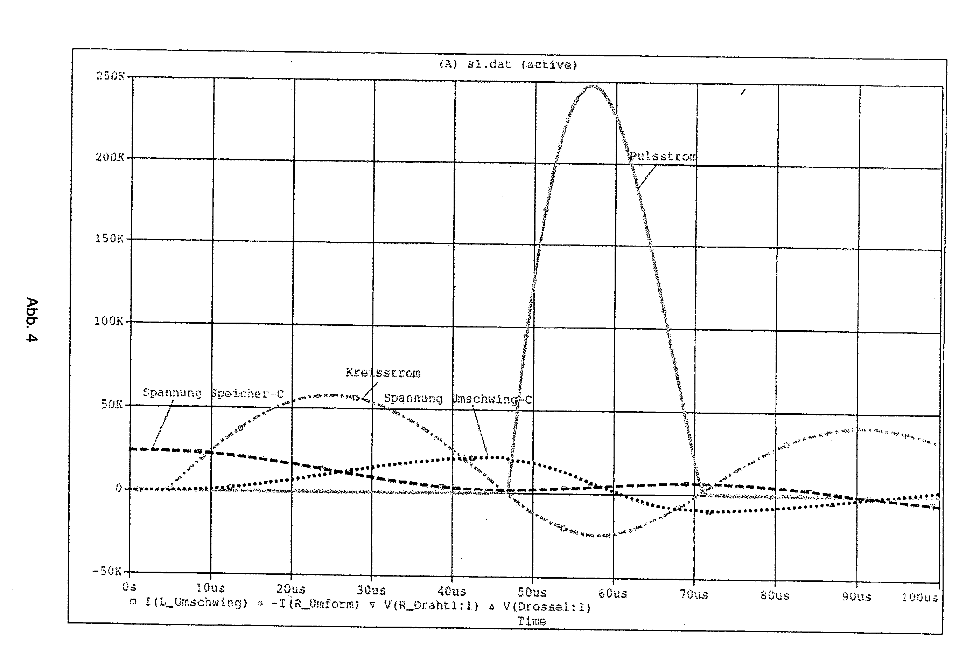

In Abb. 4 ist zu erkennen, dass der Strom durch die Umformspule $L_{Umf}$ größer als der Strom durch den Schalter $U_s$ wird.

Als Leiter der Induktivität werden rechteckige Stromschienen genutzt.

Vorteilhaft ist die Verwendung einer Dreifachanordnung, bei der die äußeren Schienen den Rückleiter bilden. Der Innenleiter bleibt kraftfrei, die Außenleiter sind durch den größeren Abstand weniger belastet. Die erforderliche Fläche, d. h. der Querschnitt durch den Kern, wird durch die Sättigungsinduktion bestimmt. Hier ist es wichtig, Materialien mit hoher Sättigungsinduktion auszuwählen und die durch den Stromfluss hervorgerufene magnetische Feldstärke muss größer sein als die Sättigungsfeldstärke auf der kompletten Dimension des Kerns.

Eisen-Kobalt-Legierungen erreichen sehr große Sättigungsinduktionen von bis zu 2,5 T, sind wegen ihres hohen Anschaffungspreises aber unattraktiv. Ein kostengünstiger

Vertreter ist zum Beispiel die kornorientierte Eisen-Silizium-Legierung 30PH105, die eine Sättigungsinduktion von $B_s$= 2,03 T hat.

Eine weitere vorteilhafte Ausführung der Erfindung ist, die Kerne der Drosselspulen mit einer magnetisch negativen Vorsättigung durch Ausnutzen der Remanenz zu versehen. Dadurch verringert sich die nötige Querschnittsfläche A

$$A = \frac{U_0}{2(B_S - B_{rem})} \pi \sqrt{L_1 \frac{C_1}{2}}$$

mit $B_{Rem}$ als negative Remanenzinduktion.

Für die Erzeugung der Remanzinduktion gibt es folgende Möglichkeiten.

a) In der Ruhezeit zwischen den Pulsen werden die Induktivitäten (die Hauptleiter) mittels eines eingespeisten negativen Gleichstroms oder entsprechender negativer Gleichstrompulse in den Remanenzzustand versetzt.

b) Ein negativen Gleichstrom bzw. negative Gleichstrompulse werden während des Pulsens in die Induktivitäten eingespeist oder als konstanter negativer Gleichstrom bzw. als konstante Gleichstrompulse aufgeprägt.

c) Der Kern wird mit einer Zusatzwicklung ausgeführt. Diese Zusatzwicklung wird wie in a) angegeben in den Ruhezeiten zwischen den Pulsen mit einem negativen Gleichstrom oder negativer Gleichstrompulse beaufschlagt.

d) Die Zusatzwicklung wird, wie in b) angegeben, während des Pulsens mit negativem Gleichstrom bzw. mit negativen Gleichstrompulsen gespeist. Auch eine konstante Aufschaltung mit negativem Gleichstrom oder negativer Gleichstrompulse ist möglich.

Ein Vorteil dieser Anordnung ist, dass die sättigbare Induktivität modular aufgebaut werden kann und damit leicht skalierbar ist.

**Patentansprüche**

1. Vorrichtung zur Stromverstärkung für die elektromagnetische Pulsumformung umfassend eine sättigbare Induktivität, wobei die sättigbare Induktivität zugleich als Zuleitung zwischen Kondensator und Umformer dient, und wobei die sättigbare Induktivität aus mindestens einer inneren Sammelschiene oder Leitung besteht, die den Strom zur Umforminduktivität hinführt, wobei um diese Sammelschiene oder Leitung das magnetisch sättigbare Material in Form von Ringbandkernen angebracht ist, und wobei an einer, an beiden oder an allen vier Seiten der sättigbaren Induktivität äußere Sammelschienen oder Leitungen angeordnet sind, die den Strom zurückführen und wobei das magnetisch sättigbare Material eine sehr große Sättigungsinduktivität, in einem Bereich von 2,03 T bis zu 2,5 T besitzt.

2. Vorrichtung nach Anspruch 1, **dadurch gekennzeichnet, dass** die Ringbandkerne aus mehreren Teilkernen bestehen.

3. Vorrichtung nach Anspruch 1 oder 2, **dadurch gekennzeichnet, dass** die Stromzuführung nicht nur an einer Seite erfolgt.

4. Vorrichtung nach Anspruch einem der vorhergehenden Ansprüche, **dadurch gekennzeichnet, dass** eine Zusatzwicklung auf dem sättigbaren Kern aufgebracht wird.

5. Verwendung der Vorrichtung nach gemäß einem der vorhergehenden Ansprüche, **dadurch gekennzeichnet, dass** eine Remanenzinduktion erzeugt wird.

**Claims**

1. A device for current amplification for electromagnetic pulse forming, comprising a saturable inductor, whereby the saturable inductor serves simultaneously as a feed line between capacitor and forming coil, and whereby the saturable inductor consists in at least one inner bus bar or line conducting the current towards the forming inductor whereby, around said bus bar or line, the magnetically saturable material is applied in form of toroidal cores, and whereby on one, on both or on all four sides of the saturable inductor outer bus bars or lines are arranged to conduct the current back, and whereby the magnetically saturable material has a very high saturation inductance ranging from 2.03 T up to 2.5 T.

2. Device according to claim 1, **characterized in that** the toroidal cores consist of several partial cores.

3. Device according to claim 1 or 2, **characterized in that** feeding in the current does not take place on one side only.

4. Device according to one of the previous claims, **characterized in that** an additional coil is applied to the saturable core.

5. Use of the device according to one of the previous claims, **characterized in that** a remanence induction is created.

**Revendications**

1. Dispositif d'amplification de courant pour le formage par impulsions électromagnétiques comprenant une inductance saturable, laquelle inductance saturable sert en même temps de ligne d'amenée entre condensateur et moyen de formage, et laquelle inductance saturable est composée d'au moins une barre collectrice ou ligne intérieure qui amène le courant à l'inductance de formage, le matériau magnétiquement saturable étant disposé en forme des noyaux toroïdaux et dans laquelle sur une, sur les deux ou sur les quatre côtés de la inductance saturable une des barres collectrices ou des lignes extérieures sont disposées qui ramènent le courant, et le matériau magnétiquement saturable possédant une inductance de saturation très élevée comprise entre 2,03 T et 2,5 T.

2. Dispositif selon la revendication 1, **caractérisé en ce que** les noyaux toroïdaux sont composés de plusieurs noyaux partiels.

3. Dispositif selon la revendication 1 ou 2, **caractérisé en ce que** l'amenée de courant n'a pas lieu seulement d'un côté.

4. Dispositif selon une des revendications précédentes, **caractérisé en ce qu'**un enroulement supplémentaire est disposé sur le noyau saturable.

5. Utilisation du dispositif selon une des revendications précédentes, **caractérisée en ce qu'**une induction rémanente est générée.

Abb. 1 - Stand der Technik

Abb. 2

L1 << L2

Abb. 3

Abb.5

Abb. 4

7

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

• US 3786334 A

**In der Beschreibung aufgeführte Nicht-Patentliteratur**

• **DIETZ, H. ; LIPPMANN, H. J. ; SCHENK, H.** Messung der magnetischen Induktion in einer Magneform-Kompressionsspule. *Elektrotechnische Zeitung,* vol. 88 (19), 51-54